# EUROPEAN PATENT SPECIFICATION

(11) **EP 3 985 406 B1**
(45) Date of publication and mention of the grant of the patent: **04.09.2024**
(21) Application number: 21188427.5
(22) Date of filing: 29.07.2021
(51) Int. Cl.: G01R 31/396

(54) **CONTROLLER AND METHOD FOR DETECTING BATTERY CELL VOLTAGE**
STEUERGERÄT UND VERFAHREN ZUR ERFASSUNG EINER BATTERIEZELLENSPANNUNG
ORGANE DE COMMANDE ET PROCÉDÉ DE DÉTECTION DE TENSION DE CELLULE DE BATTERIE

(30) Priority: 16.10.2020 CN 202011107626; 06.07.2021 US 202117368637
(43) Date of publication of application: 20.04.2022
(73) Proprietor: O2Micro, Inc., Santa Clara, CA 95054 (US)
(72) Inventor: Li, Guoxing, Sunnyvale 94089 (CN); Li, Yan, Wuhan (CN); Liu, Hui, Wuhan (CN)
(74) Representative: Lippert Stachow Patentanwälte Rechtsanwälte

(56) References cited:
- WO-A1-2019/208172
- CN-A- 104 678 160
- CN-C- 100 463 435
- JP-A- 2001 056 350
- US-A1- 2006 186 894
- US-A1- 2008 100 266
- US-A1- 2009 195 213
- US-A1- 2009 295 396
- US-A1- 2010 173 183
- US-A1- 2010 289 497
- US-A1- 2013 214 789
- US-A1- 2015 015 209
- US-B2- 10 128 548

## Description

### RELATED APPLICATION

This application claims priority to Chinese Patent Application No. 202011107626.4, titled "Controller and Method for Detecting Battery Cell Voltage," filed on October 16, 2020, with the National Intellectual Property Administration of the People's Republic of China (CNIPA).

### BACKGROUND

In recent years, batteries have been widely used in power tools, electric bicycles, electric vehicles, military equipment, aerospace and other fields. A voltage of a battery cell represents a potential difference between an anode and a cathode of the battery cell and is one of the important indicators to measure the charge and discharge performance of the battery.

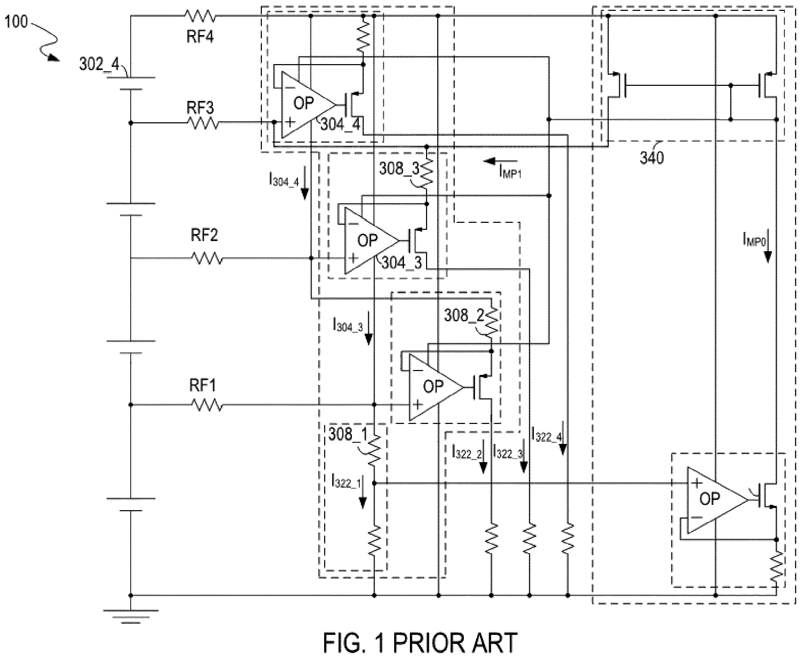

FIG. 1 is a circuit diagram of a conventional battery voltage detection system 100. The conversion system 100 uses a compensation current I_{MP1} generated by a current mirror 340 to compensate the sampling current I_{322_3} flowing from a resistor RF3 to a resistor 308_3, uses an operating current I_{304_4} of the operational amplifier 304_4 to compensate the sampling current I_{322_2} flowing from a resistor RF2 to a resistor 308_2, and uses an operating current I_{304_3} of the operational amplifier 304_3 to compensate the sampling current I_{322_1} flowing from a resistor RF1 to a resistor 308_1. In an ideal state, the currents flowing through the resistors RF3, RF2 and RF1 are all zero due to the compensation. However, since the current flowing through the resistor RF4 is relatively large, the voltage drop generated on the resistor RF4 is also relatively large, resulting in a low accuracy of the detected voltage V_{302_4} of the battery cell 302_4 which is indicated by the sampling current I_{322_4}.
US 2010/173183 discloses an arrangement for measuring voltages of individual cells in a battery, comprising, for each cell, a resistive divider and a voltage to current converter. Each voltage to current converter is connected to a cathode (low side) of a battery cell via an enable switch and a lower resistor of a divider, and further switchably connected to an anode (high side) of the cell via the enable switch, wherein the output or operational current flows to ground. Similar art is known from CN104678160, US2010/289497, WO2019/208172, and US2009/295396.

### SUMMARY

Disclosed are embodiments of methods for detecting voltages of battery cells in a battery pack. The battery cells correspond to respective converters, an anode of each battery cell is coupled to a respective converter through a respective first path, a cathode of each battery cell is coupled to the respective converter through a respective second path, and the converters are coupled to anodes of the battery cells through switching units. The method includes: turning on a switching unit corresponding to a battery cell to enable an anode of the battery cell to provide an operating current and a sampling current through a respective first path to a respective converter, where the operating current flows from the anode of the battery cell through the respective converter to ground; and detecting a voltage of the battery cell by a respective converter. Said method further comprises: duplicating, by a mirroring unit, an operating current and a sampling current of a first converter of said plurality of converters corresponding to a first battery cell of said plurality of battery cells, to reduce a difference between a current through a first path of said plurality of first paths that corresponds to said first converter and a current through a second path of said plurality of second paths that corresponds to said first converter, wherein said mirroring unit is coupled to said second path that corresponds to said first converter.

In other embodiments, a controller for detecting voltages of battery cells in a battery pack includes converters coupled to the battery cells and switching units, where an anode of each battery cell is coupled to a respective converter through a respective first path, a cathode of each battery cell is coupled to the respective converter through a respective second path. The switching units are coupled between the battery cells and the converters. The converters are coupled to anodes of the battery cells through the switching units. When a switching unit corresponding to a battery cell is turned on, an anode of the battery cell provides an operating current and a sampling current through a respective first path to a respective converter, where the operating current flows from the anode of the battery cell through the respective converter to ground. Said controller further comprises: a mirroring unit coupled to a second path of said plurality of second paths that corresponds to a first converter of said plurality of converters that corresponds to a first battery cell of said plurality of battery cells, wherein said mirroring unit is operable for duplicating an operating current and a sampling current of said first converter to reduce a difference between a current through a first path of said plurality of first paths that corresponds to said first converter and a current through said second path that corresponds to said first converter.

### BRIEF DESCRIPTION OF THE DRAWINGS

Features and advantages of embodiments of the claimed subject matter will become apparent as the following detailed description proceeds, and upon reference to the drawings, wherein like numerals depict like parts, and in which:
FIG. 1 shows a circuit diagram of a conventional battery voltage detection system.
FIG. 2 shows a circuit diagram of an exemplary controller.
FIG. 3 shows an exemplary timing diagram of multiple switching units in a controller.
FIG. 4 shows a circuit diagram of a controller, in accordance with embodiments of the present invention.
FIG. 5 shows a timing diagram of multiple switching units in a controller, in accordance with embodiments of the present invention.
FIG. 6 shows a circuit diagram of a controller, in accordance with embodiments of the present invention.
FIG. 7 shows a timing diagram of multiple switching units in a controller, in accordance with embodiments of the present invention.
FIG. 8 shows a timing diagram of multiple switching units in a controller, in accordance with embodiments of the present invention.
FIG. 9 shows a flowchart of a method for detecting battery cell voltages.

### DETAILED DESCRIPTION

Reference will now be made in detail to the embodiments of the present invention. While the invention will be described in combination with these embodiments, it will be understood that they are not intended to limit the invention to these embodiments. On the contrary, the invention is intended to cover alternatives, modifications and equivalents, which may be included within the scope of the invention as defined by the appended claims.

Furthermore, in the following detailed description of the present invention, numerous specific details are set forth in order to provide a thorough understanding of the present invention. However, it will be recognized by one of ordinary skill in the art that the present invention may be practiced without these specific details. In other instances, well known methods, procedures, components, and circuits have not been described in detail to avoid obscuring aspects of the present invention.

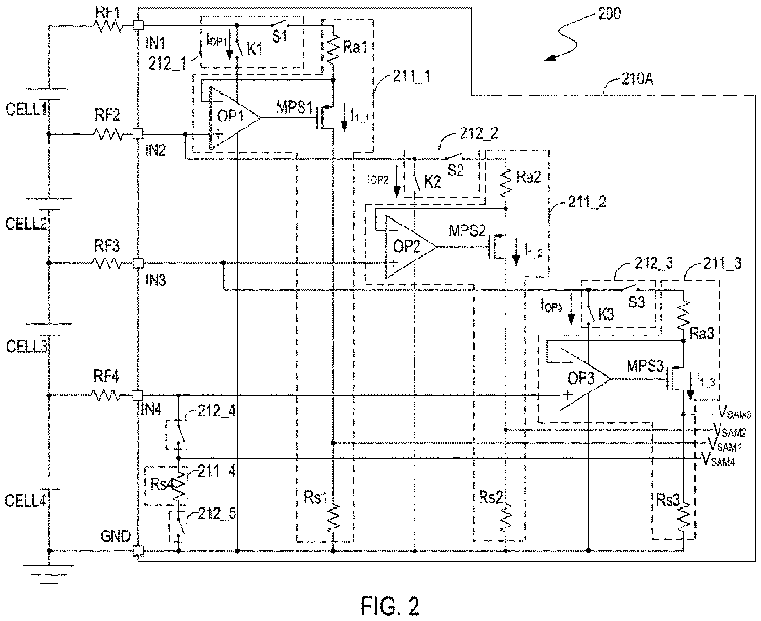

FIG. 2 shows a circuit diagram 200 of a controller 210A for detecting voltages of battery cells in a battery pack. The example battery pack in FIG. 2 includes battery cells CELL1, CELL2, CELL3, and CELL4, and the controller 210A includes converters 211_1-211 4 corresponding to the battery cells CELL1-CELL4, respectively. In this example, the battery cell CELL1 is called the top battery cell (i.e., the battery farthest from the reference ground GND), and the battery cell CELL4 is called the bottom battery cell (i.e., the battery closest to the reference ground GND).

The anode of the battery cell CELLj (j=1, 2, or 3) is coupled to the converter 211_j through a first path, and the cathode of the battery cell CELLj is coupled to the converter 211J through a second path. The controller 210A further includes switching units 212_1-212_4 coupled between the battery cells CELL1-CELL4 and the converters 211_1-211_4, respectively. The converters 211_1-211 4 are coupled to anodes of the battery cells CELL1-CELL4 through the switching units 212_1-212 4, respectively. When a corresponding switching unit of each battery cell is turned on, an operating current I_{OPj} and a sampling current I_{1_j} provided by the anode of the battery cell CELLj flow through a first path corresponding to the converter 211_j. The operating current I_{OPj} flows from the anode of the battery cell CELLj through the first path and the corresponding converter 211_j to ground. An operating current I_{OP(j+1)} and a sampling current I_{1_(j+1)} provided by the anode of the battery cell CELL(j+1) flow through a second path corresponding to the converter 211_j. In an example, the first path corresponding to the converter 211_j includes a connecting resistor RFj. The second path corresponding to the converter 211_j includes a connecting resistor RF(j+1). For the battery cell CELL4, the anode of the battery cell CELL4 is coupled to the converter 211_4 via the connecting resistor RF4 and the switching unit 212_4, and the cathode of the battery cell CELL4 is coupled to the converter 211_4 via the switching unit 212_5. In one example, the resistance of the connecting resistors RF1, RF2, RF3, and RF4 are equal.

The converter 211_j can be enabled or disabled by turning on or turning off the switching unit 212_j (j=1, 2, or 3). For example, by turning on the switching unit 212_1 (e.g., switches S1 and K1), the converter 211_1 is enabled, and by turning off the switching unit 212_1, the converter 211_1 is disabled. In an example, the switching unit 212_j (j=1, 2, or 3) includes a switch Sj and a switch Kj. By turning on the switch Kj, the anode of the battery cell CELLj provides the converter 211_j with the operating current I_{OPj} through the first path corresponding to the converter 211_j. By controlling the switch Kj, the operational amplifier OPj in the converter 211_j can be enabled or disabled individually to save power. By turning on the switch Sj, the anode of the battery cell CELLj provides the sampling current I_{1_j} to the converter 211_j through the first path corresponding to the converter 211_j.

In addition, when the switching units 212_4 and 212_5 are on at the same time, the converter 211_4 is enabled, and by turning off any one of the switching units 212_4 and 212_5, the converter 211_4 is disabled. When the switching units 212_4 and 212_5 are on at the same time, the sampling current I_{1_4} (not shown in the figure) and the operating current I_{OP4} (not shown in the figure) provided by the anode of the cell CELL4 flow through the converter 211_4.

The converter 211_j detects the voltage of the cell CELLj and generates a sampling signal SAMj (j=1, 2, 3, or 4). In an example, the sampling signal SAMj can be a sampling current I_{1_j}. Specifically, the converter 211_j converts the voltage of the cell CELLj to the sampling current I_{1_j}, thereby indicating the voltage of the cell CELLj. In another example, the sampling signal SAMj can be a sampling voltage V_{SAMj}. Specifically, the sampling current I_{1_j} (j=1, 2, 3, or 4) flows through the sampling resistor Rsj and is detected as the sampling voltage V_{SAMj}. In an example, the sampling voltages V_{SAMj} (j = 1, 2, 3, 4) are all based on the same reference voltage (for example, ground).

In an example, the converter 211_j (j=1, 2, or 3) includes an operational amplifier OPj, a resistor Raj, a transistor MPSj, and a sampling resistor Rsj. The operational amplifier OPj (j=1, 2, or 3) is coupled to the anode of the battery cell CELLj through the switch Kj, and the operating current IOPj flows from the anode of the battery cell CELLj to the ground via the connecting resistor RFj and the operational amplifier OPj. The resistor Raj is coupled to the anode of the cell CELLj through the switch Sj, and the sampling current I_{1_j} flows from the anode of the cell CELLj to the ground via the connecting resistor RFj, the resistor Raj, and the sampling resistor Rsj. The converter 211-4 includes a sampling resistor Rs4. The operating modes of the controller 210A in FIG. 2 can include the following two modes.

In a first operating mode, the controller 210A turns on all the switching units 212_1-212_4 in FIG. 2, so that the converters 211_1-211_4 are all enabled. The converter 211_j (j=1, 2, or 3) receives the operating current I_{OPj} and the sampling current I_{1_j} provided by the cell CELLj through the first path corresponding to the converter 211_j. The operating current I_{OP(j+1)} and the sampling current I_{1_(j+1)} provided by the lower cell CELL(j+1) adjacent to the cell CELLj flow through the second path corresponding to the converter 211_j. In an example, in an ideal state, by properly setting the parameters of related components, the sum of the operating current and the sampling current provided by each battery cell can be approximately equal. The converter 211_j detects the voltage of the battery cell CELLj, and generates a sampling signal SAMj (for example, the sampling voltage V_{SAMj} or the sampling current I_{1_j}) indicating the voltage of the battery cell CELLj.

In addition, when detecting the voltage of the battery cell CELL4, the battery cell CELL4, the connecting resistor RF4, and the converter 211_4 constitute a closed loop. The converter 211-4 detects the voltage of the battery cell CELL4 and generates a sampling signal SAM4 (e.g., the current flowing through the converter 211_4 or the voltage on the converter 211-4) indicating the voltage of the battery cell CELL4.

Compared to FIG. 1, the controller 210A in FIG. 2 changes the power supply method for the operational amplifier in each converter so that the current flowing through the first path and the current flowing through the second path corresponding to each converter both are the sum of the operating current and sampling current provided by the anodes of the two adjacent battery cells. In an ideal state, by properly setting the parameters of the relevant components, the operating current of each operational amplifier can be approximately equal, and each sampling current can be approximately equal. In an embodiment, since the resistances of the connecting resistors are set to be equal, with the above conditions, the voltage drop on each connecting resistor is also approximately equal. Therefore, compared with the system in FIG. 1, the controller 210A can detect the voltage of each battery cell more accurately. However, since the anode of each battery cell provides the operating current and sampling current for the corresponding converter, the current flowing through the battery cells CELL1, CELL2, CELL3, and CELL4 increases in sequence. After the controller 210A operates for a relatively long time, the balance between the voltages of the individual cells may be lost (balance means that the voltage differences of the individual cells are within an acceptable range), which would reduce the accuracy of the detected voltage of each cell represented by each sampling signal. To address this, the arrangement includes a second operating mode of the controller 210A.

In the second operating mode, the controller 210A selectively turns on the switching units (for example, the switching units 212_j, 212_(j+1)) corresponding to two adjacent battery cells (for example, battery cells CELLj, CELL(j+1), j = 1, 2, 3) to enable two adjacent converters (e.g., converters 211_j, 211_(j+1)) while other converters remain disabled.

An upper converter (e.g., the converter 211 _j) of the two adjacent converters (e.g. converters 211_j, 211_(j+1), j = 1, 2, 3) receives an operating current I_{OPj} and a sampling current I_{1_j} from an anode of an upper cell (e.g., CELLj) of two adjacent cells through a first path corresponding to the upper converter. An operating current I_{OP(j+1)} and a sampling current I_{1_(j+1)} from an anode of a lower cell (e.g., CELL(j+1)) of the two adjacent cells flows through a second path corresponding to the upper converter (e.g. the converter 211_j). The upper converter (e.g. the converter 211_j) detects a voltage of the upper cell (e.g., CELLj).

To detect the voltage of CELL4, the controller 210A can turn on both switching units 212_4 and 212_5, or can turn on switching unit 212_4 and turn off switching unit 212_5. Both methods can enable the controller 210A to accurately detect a voltage of the battery cell CELL4.

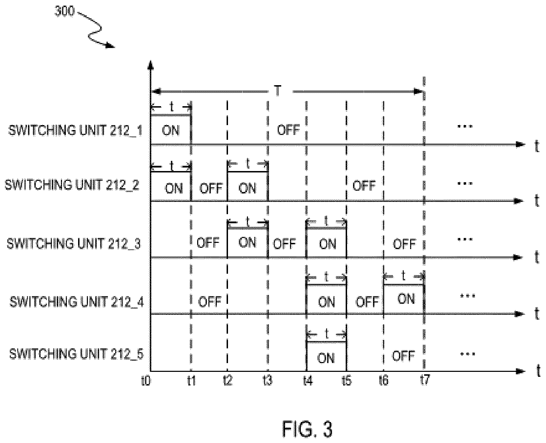

In the second operating mode, by controlling the duty cycle of the on-time of the switching units corresponding to the two adjacent battery cells, an average value of the difference between the currents flowing through each battery cell can be reduced, thereby maintaining balance among battery cells. The duty cycle refers to the ratio of the on-time t of the switching units corresponding to the two adjacent battery cells to the detection period T. The detection period T refers to the total time required to detect the voltages of all the battery cells CELL1, CELL2, CELL3, and CELL4. The details will be described in Figure 3.

FIG. 3 shows a timing diagram of the switching units in controller 210A operating in the second mode, in accordance with examples of the present invention. In the example shown in FIG. 3, during the time period from t0 to t1, only the switching units 212_1 and 212_2 are turned on, and the converter 211_1 detects the voltage of the cell CELL1. During the time period from t2 to t3, only the switching units 212_2 and 212_3 are turned on, and the converter 211_2 detects the voltage of the cell CELL2. In the time period from t4 to t5, only the switching units 212_3, 212_4, and 212_5 are turned on, and the converter 211_3 detects the voltage of the cell CELL3. During the time period from t6 to t7, only the switching unit 212_4 is turned on, and the converter 211_4 detects the voltage of the cell CELL4. In this embodiment, t1-t0 = t3-t2 = t5-t4 = t7-t6. In other examples, t1-t0, t3-t2, t5-t4, and t7-t6 may not be equal.

Assume, for example, that the detection period T in FIG. 3 is 100ms, and the on-time t of the switching units corresponding to two adjacent battery cells are both 100ps, in which case the duty cycle is 100µs/100ms. Assume also that the current received by each converter through a corresponding first path is 10µA. In this example, when the controller 210A operates in the first mode, the difference between the current flowing through the battery cell CELL1 and the current flowing through the battery cell CELL3 is 20µA. When the controller 210A operates in the manner shown in FIG. 3 (second mode), during the detection period T, the average value of the difference between the current flowing through the cell CELL1 and the current flowing through the cell CELL3 is reduced to 20nA in this example. It can be seen that by controlling (for example, reducing) the duty cycle of the on-time t of the switching units corresponding to two adjacent battery cells as in the second mode, the average value of the difference between the currents flowing through the battery cells can be reduced, thereby maintaining balance among battery cells.

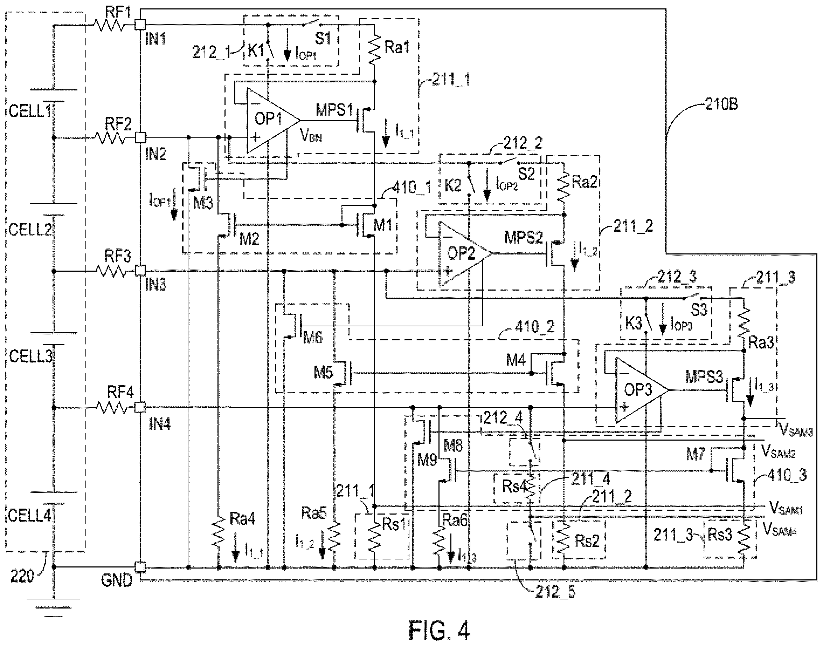

FIG. 4 shows a circuit diagram of a controller 210B, in accordance with embodiments of the present invention.

Compared with the controller 210B in FIG. 2, the controller 210B further includes multiple mirroring unit. In the example of FIG. 4, the controller 210B includes mirroring unit 410_1, 410_2 and 410_3.

The mirroring unit 410_j (j = 1, 2, or 3) duplicates the operating current I_{OPj} and the sampling current I_{1_j} of the converter 211_j corresponding to the battery cell CELLj, so as to reduce the difference between the current through the first path corresponding to the converter 211_j and the current through the second path corresponding to the converter 211_j. The mirroring unit 410_j is coupled to the second path corresponding to the converter 211J.

Specifically, the mirroring unit 410_j (j=1, 2, or 3) generates a first duplicated current proportional to the operating current I_{OPj}. In an embodiment, in an ideal state, the first duplicated current can be approximately equal to the operating current I_{OPj} by properly setting parameters of the relevant components. The mirroring unit 410_j (j=1, 2, or 3) generates a second duplicated current proportional to the sampling current I_{1_j}. In an embodiment, in an ideal state, the second duplicated current can be approximately equal to the sampling current I_{1_j} by properly setting the parameters of the relevant components. The operating current I_{OPj} and the sampling current I_{1_j} flow through the first path corresponding to the converter 211_j. The first duplicated current and the second duplicated current flow through the second path corresponding to the converter 211_j.

In an embodiment, each mirroring unit includes a first branch, a second branch, and a third branch. The sampling current I_{1_j} flows through the first branch coupled to the converter 211_j (j=1, 2, or 3). The second branch coupled to the first branch generates a first duplicated current proportional to the sampling current I_{1_j}. The first duplicated current flows from the second path corresponding to the converter 211_j to the second branch. The third branch coupled to the converter 211_j generates a second duplicated current proportional to the operating current I_{OPj}. The second duplicated current flows from the second path corresponding to the converter 211_j to the third branch.

In the embodiment shown in FIG. 4, the mirroring unit 410_1 includes a first branch, a second branch, and a third branch. The first branch includes a transistor M1, the second branch includes a transistor M2, and the third branch includes a transistor M3. The gate of the transistor M1 is coupled to the gate of the transistor M2 to constitute a current mirror structure, and the gate of the transistor M3 is coupled to components related to the operating current I_{OP1} inside the operational amplifier OP1 to constitute a current mirror structure. The sampling current I_{1_1} flows to the ground via the transistor M1. The transistor M2 duplicates the sampling current I_{1_1} flowing through the transistor M1 to generate a first duplicated current. The first duplicated current flows to the transistor M2 via the second path corresponding to the converter 211_1. The transistor M3 duplicates the operating current I_{OP1} of the converter 211_1 to generate a second duplicated current. The second duplicated current flows to the transistor M3 via the second path corresponding to the converter 211_1. In the FIG. 4 embodiments, the structures of the mirroring unit 410_2 and 410_3 are the same as that of the mirroring unit 410_1.

In operation, the controller 210B in FIG. 4 selectively turns on the switching unit 212J corresponding to the battery cell CELLj (j=1, 2, or 3), the converter 211_j corresponding to the battery cell CELLj is enabled, and other converters are disabled. The mirroring unit 410_j corresponding to the battery cell CELLj is enabled to duplicate the current flowing through the first path corresponding to the converter 211_j. The voltage of the cell CELLj is detected by the converter 211_j.

For example, to detect the voltage of the cell CELL1, the switches S1 and K1 are turned on, and the converter 211_1 and the mirroring unit 410_1 are enabled. The mirroring unit 410_1 duplicates the current through the first path corresponding to the converter 211_1 to the second path corresponding to the converter 211_1. In an ideal state, with the duplicated current produced by the mirroring unit 410_1 , the current through the first path corresponding to the converter 211_1 is approximately equal to the current through the second path corresponding to the converter 211_1. The converter 211_1 detects the voltage of the cell CELL1 and generates a sampling signal SAM1 indicating the voltage of the cell CELL1.

The process of detecting the voltages of the battery cell CELL2 and CELL3 is similar to that of detecting the voltage of the battery cell CELL1. The process of detecting the voltage of the battery cell CELL4 is similar to that described with FIG. 2.

According to the above description, by using the mirroring units, the current through the first path corresponding to the converter 211_i (i=1, 2, or 3) can be approximately equal to the current through the second path corresponding to the converter 211_i, so that the sampling signal can accurately indicate the voltage of the corresponding cell. Furthermore, by controlling (for example, reducing) the duty cycle of the on-time t of the switching unit corresponding to each battery cell, an average value of the differences between currents flowing through the battery cells can be reduced, thereby maintaining balance among the cells. The duty cycle refers to the ratio of the on-time t of each switching unit to the detection period T.

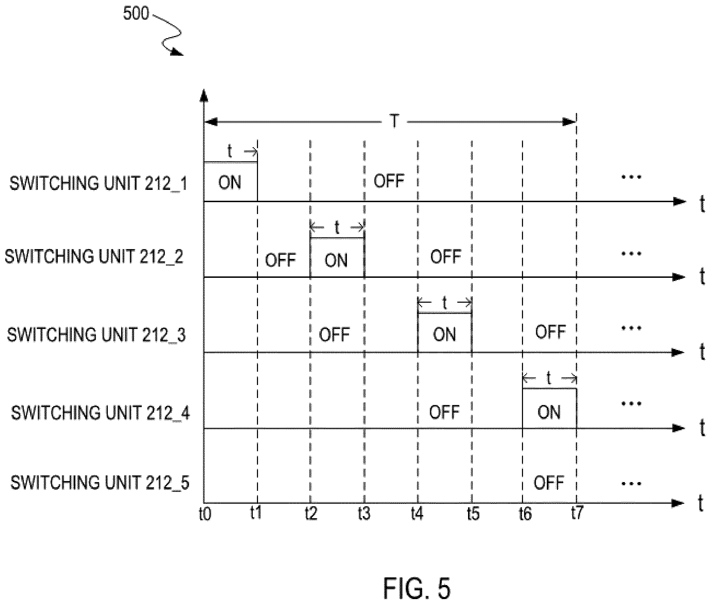

FIG. 5 shows a timing diagram of the switching units in the controller 210B in FIG. 4. In the embodiment shown in FIG. 5, during the time period from t0 to t1, only the switching unit 212_1 is turned on, and the converter 211_1 detects the voltage of the cell CELL1. In the time period from t2 to t3, only the switching unit 212_2 is turned on, and the converter 211_2 detects the voltage of the cell CELL2. In the time period from t4 to t5, only the switching unit 212_3 is turned on, and the converter 211_3 detects the voltage of the cell CELL3. During the time period from t6 to t7, only the switching unit 212_4 is turned on, and the converter 211_4 detects the voltage of the cell CELL4. In this embodiment, t1-t0 = t3-t2 = t5-t4 = t7-t6. In other embodiments, t1-t0, t3-t2, t5-t4, and t7-t6 may not be equal.

By controlling (for example, reducing) the duty cycle of the on-time t of each switching unit, an average value of the difference between the current flowing through each battery cell can be reduced, thereby maintaining balance among the cells.

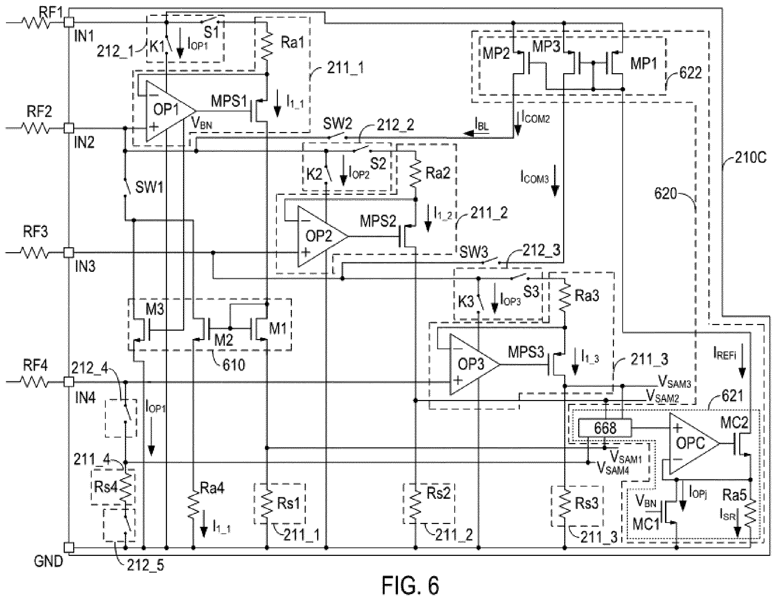

Fig. 6 shows a circuit diagram of a controller 210C in accordance with embodiments of the present invention.

Compared with the controller 210A in FIG. 2, the controller 210C shown in FIG. 6 further includes a mirroring unit 610 and a compensation circuit 620.

The mirroring unit 610 is coupled to the second path corresponding to the top cell CELL1, and is operable for duplicating the operating current I_{OP1} and the sampling current I_{1_1} of the converter 211_1 corresponding to the top battery cell, to reduce the difference between the current flowing through the first path corresponding to the converter 211_1 and the current flowing through the second path corresponding to the converter 211_1.

Specifically, to detect the voltage of the cell CELL1, the switching unit 212_1 and the switch SW1 are turned on, and the converter 211_1 and the mirroring unit 610 are enabled. The operating current I_{OP1} and the sampling current I_{1_1} provided by the anode of the battery cell CELL1 flow through the first path corresponding to the converter 211_1. The mirroring unit 610 duplicates the current flowing through the first path corresponding to the converter 211_1 to the second path corresponding to the converter 211_1, thereby reducing the difference between the current flowing through the first path corresponding to the converter 211_1 and the current flowing through the second path corresponding to the converter 211_1. In an embodiment, in an ideal state, by properly setting the parameters of related components and by using the mirroring unit 610, the current flowing through the first path corresponding to the converter 211_1 is approximately equal to the current flowing through the second path corresponding to the converter 211_1. Therefore, the converter 211_1 can accurately detect the voltage of the battery cell CELL1.

The compensation circuit 620 is coupled to converters 211_1-211 4, and is operable for generating one or more compensation currents to compensate the currents of the first paths corresponding to one or more cells. The one or more battery cells can be battery cells other than the top battery cell (for example, battery cells CELL2 and CELL3).

Specifically, to detect the voltage of the battery cell CELLj (j=2 or 3), the switching unit 212J and the switch SWj are turned on, and the converter 211_j and the compensation circuit 620 are enabled. The converter 211_j receives the operating current I_{OPj} and the sampling current I_{1_j} provided by the cell CELLj through the first path corresponding to the converter 211_j. The compensation circuit 620 generates a compensation current I_{COMj} according to the operating current I_{OPj} and the sampling current I_{1_j} to compensate the current flowing through the first path corresponding to the battery cell CELLj.

In an embodiment, the compensation circuit 620 includes a detection unit 621 coupled to the multiple converters, and a compensation unit 622 coupled to the detection unit 621. The detection unit 621 samples the operating current and the sampling current of the converters, and generates a respective reference current proportional to a sum of the operating current and the sampling current.

Specifically, to detect the voltage of the battery cell CELLj (j = 2 or 3), the switching unit 212J is turned on, the converter 211_j is enabled, and the anode of the battery cell CELLj provides the operating current I_{OPj} and sampling current I_{1_j} to the converter 211_j through the corresponding first path. The switch SWj is turned on, and the detection unit 621 samples the operating current I_{OPj} and the sampling current I_{1_j}, and generates a reference current I_{REFj} that is proportional to the sum of the operating current I_{OPj} and the sampling current I_{1_j}.

In an embodiment, the detection unit 621 includes a selector 668, an operational amplifier OPC, a transistor MC1, a resistor Ra5, and a transistor MC2. The selector 668 is operable for selecting one sampling signal V_{SAMi} from among multiple sampling signals. In an embodiment, the sampling signal V_{SAMi} selected by the selector 668 is the sampling voltage corresponding to the battery cell CELLj. The transistor MC1 is respectively coupled to components related to the operating current I_{OPj} in the operational amplifier OPj (j = 1, 2, or 3) to constitute a current mirror that is operable for duplicating the operating current I_{OPj} of the operational amplifier OPj. The sampling voltage V_{SAMi} selected by the selector 668 is applied to the resistor Ra5 to generate a current I_{SR}. The sum of the operating current I_{OPj} and the current I_{SR} is the reference current I_{REFi}. The reference current I_{REFi} flows through the transistor MC2 to ground. In an ideal state, by properly setting the parameters of related components, the current I_{SR} can be approximately equal to the sampling current I_{1_i}, and the reference current I_{REFi} can be proportional to the sum of the operating current I_{OPj} and the current I_{SR}.

The compensation unit 622 generates a compensation current I_{COMj} that is proportional to the reference current I_{REFj} (j=2 or 3). The compensation current I_{COMj} compensates the current flowing through the first path corresponding to the battery cell CELLj.

Specifically, the compensation unit 622 duplicates the reference current I_{REFj} (j=2 or 3) to generate the compensation current I_{COMj}. When the switch SWj is turned on, the compensation current I_{COMj} flows from the compensation unit 622 to the first path corresponding to the battery cell CELLj. In an ideal state, by properly setting the parameters of the relevant components, the magnitude of the compensation current I_{COMj} (j = 2 or 3) is approximately equal to the sum of the operating current I_{OPj} and the sampling current I_{1_j}, such that the overall current flowing through the first path corresponding to the converter 211_j is equal to zero. Meanwhile, since the switching unit 212_(j+1) is turned off, the current flowing through the second path corresponding to the converter 211_j is also zero. Because the current flowing through the first path corresponding to the converter 211_j and the current flowing through the second path corresponding to the converter 211_j are both zero, the converter 211_j can accurately detect the voltage of the battery cell CELLj.

In an embodiment, the compensation unit 622 includes transistors MP1, MP2, and MP3. The transistor MP1 and the transistors MP2 and MP3 constitute a current mirror that is operable for duplicating the reference current I_{REFj} flowing through the transistor MP1 to generate a corresponding compensation current I_{COMj}. When the switch SWj (j=2 or 3) is turned on, the compensation current I_{COMj} flows from the compensation unit 622 to the first path corresponding to the converter 211_j, so that the overall current flowing through the first path corresponding to the converter 211_j is approximately equal to zero.

According to the above description, the converters can accurately detect the voltage of each battery cell. However, when detecting the voltage of the battery cell CELL1, the duplicated current generated by the mirroring unit 610 flows from a node between the cathode of the battery cell CELL1 and the anode of the battery cell CELL2 through the resistor RF2, causing the current flowing through the battery cell CELL1 to be less than the current flowing through other battery cells. This will cause the battery pack to lose its balance. To address this, the compensation circuit 620 in the controller 210C according to an embodiment of the present invention is further operable for generating a balancing current I_{BL}. When the switch SW2 is turned on, the balancing current I_{BL} flows from the compensation unit 622 through the second path corresponding to the converter 211_1 to the cathode of the top battery cell CELL1, and further flows to the anode of the top battery cell CELL1 to reduce the difference between the current flowing through the top battery cell and the current flowing through other battery cells, thereby maintaining balance among each cell.

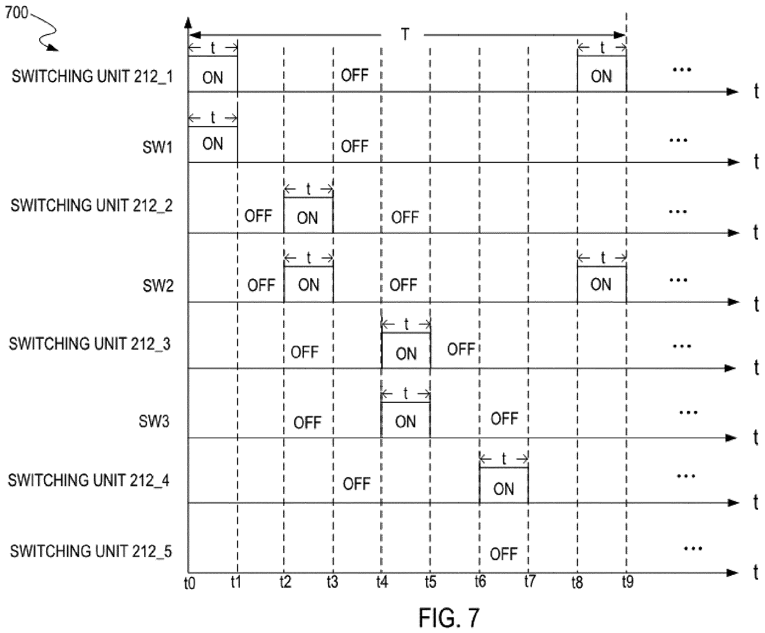

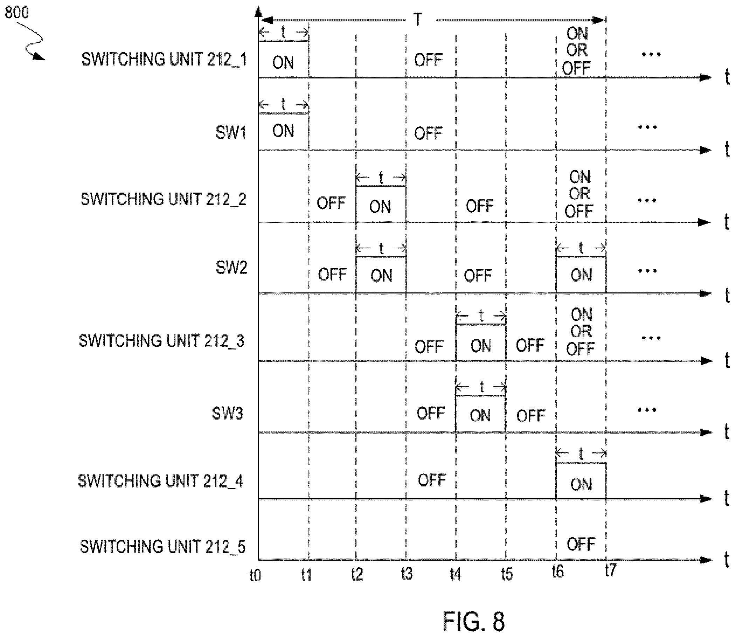

FIG. 7 and FIG. 8 show timing diagrams associated with the controller 210C. In an embodiment as shown in FIG. 7, in a detection period T, the controller 210C first detects the voltage of each battery cell once (e.g., from CELL1 to CELL4), and then enables the converter 211_1 corresponding to the top battery cell CELL1 again. The compensation circuit 620 generates a balancing current I_{BL} proportional to the sum of the operating current I_{OP1} and the sampling current I_{1_1} of the converter 211_1. In another embodiment as shown in FIG. 8, when detecting the voltage of the cell CELLi, the compensation circuit 620 generates a balancing current I_{BL} proportional to the sum of the operating current I_{OPi} and the sampling current I_{1_i} of the converter 211_i corresponding to the cell CELLi. In the example of FIG. 8, CELLi is CELL4. In other examples, CELLi may be any battery cell other than the top battery cell CELL1 and the lower battery cell adjacent to the top battery cell (i.e., CELL2). A detailed description is given below.

FIG. 7 shows a timing diagram of multiple switching units in the controller 210C in FIG. 6, in accordance with embodiments of the present invention.

In the time period from t0 to t1, the controller 210C detects the voltage of the battery cell CELL1. The switching unit 212_1 and the switch SW1 are turned on, and the converter 211_1 and the mirroring unit 610 are enabled. The mirroring unit 610 duplicates the current flowing through the first path corresponding to the converter 211_1 to the second path corresponding to the converter 211_1. The converter 211_1 detects the voltage of the cell CELL1 and generates a sampling signal SAM1 indicating the voltage of the cell CELL1. During this time period, there is current flowing through the second path corresponding to the converter 211_1, and thereby the current flowing through the battery cell CELL1 is less than the current flowing through other battery cells.

During the time period from t2 to t3, the controller 210C detects the voltage of the battery cell CELL2, and during the time period from t4 to t5, the controller 210C detects the voltage of the battery cell CELL3. When the voltage of the cell CELLj (j=2 or 3) is detected, only the switching unit 212_j and the switch SWj are turned on, and the converter 211_j and the compensation circuit 620 are enabled. The anode of the battery cell CELLj provides the operating current I_{OPj} and the sampling current I_{1_j} to the converter 211_j through the corresponding first path. The detection unit 621 samples the operating current I_{OPj} and the sampling current I_{1_j}, and generates a reference current I_{REFj} proportional to the sum of the operating current I_{OPj} and the sampling current I_{1_j}. The compensation unit 622 generates a compensation current I_{COMj} according to the reference current I_{REFj}. The compensation current I_{COMj} compensates the current through the first path corresponding to the battery cell CELLj. Due to the effect of the compensation current I_{COMj}, the current flowing through the first path corresponding to the battery cell CELLj is reduced. In an ideal state, by properly setting the parameters of the relevant components, the compensation current I_{COMj} (j = 2 or 3) is approximately equal to the sum of the operating current I_{OPj} and the sampling current I_{1_j}, so that the overall current flowing through the first path corresponding to the converter 211_j is approximately equal to zero. During this time period, since the switching unit 212_(j+1) is off, the current flowing through the second path corresponding to the converter 211_j is also zero. Therefore, the converter 211_j can accurately detect the voltage of the battery cell CELLj.

During the time period from t6 to t7, the controller 210C detects the voltage of the battery cell CELL4. The process of detecting the voltage of the battery cell CELL4 is similar to that described with FIG. 2.

During the time period from t8 to t9, the controller 210C compensates the current consumed by the cell CELL1. The switching unit 212_1 and the switch SW2 are turned on again, and the converter 211_1 and the compensation circuit 620 are enabled. The anode of the battery cell CELL1 provides the converter 211_1 with the operating current I_{OP1} and the sampling current I_{1_1}. The compensation circuit 620 samples the operating current I_{OP1} and the sampling current I_{1_1} and generates a balancing current I_{BL} that is proportional to the sum of the operating current I_{OP1} and the sampling current I_{1_1}. The balancing current I_{BL} flows from the cathode of the battery cell CELL1 to the anode of the battery cell CELL1. In this example, the balancing current I_{BL} only increases the current flowing through the battery cell CELL1. In an ideal state, by properly setting the parameters of related components, the balancing current I_{BL} is approximately equal to the sum of the operating current I_{OP1} and the sampling current I_{1_1}. This method can accurately compensate the reduced current consumed by the battery cell CELL1.

In this embodiment, t1-t0 = t3-t2 = t5-t4 = t7-t6 = t9-t8. In other embodiments, t1-t0, t3-t2, t5-t4, t7-t6, and t9-t8 may not be equal.

FIG. 8 shows another timing diagram of multiple switching units in the controller 210C in FIG. 6, in accordance with embodiments of the present invention. In the time period from time t0 to t6, the process of detecting the voltages of the battery cells CELL1, CELL2, and CELL3 is similar to that described with FIG. 7.

In the time period from t6 to t7, the controller 210C detects the voltage of the battery cell CELL4. The switching unit 212_4 is turned on and the switching unit 212_5 is turned off. The converter 211_4 detects the voltage of the cell CELL4 and generates a sampling voltage V_{SAM4} indicating the voltage of the cell CELL4. The compensation circuit 620 turns on any one of the switching units 212_1-212_3, samples the operating current of the operational amplifier corresponding to the turned-on switching unit, and samples the sampling voltage V_{SAM4} to generate a balancing current I_{BL}. The balancing current I_{BL} flows from the cathode of the battery cell CELL1 to the anode of the battery cell CELL1. In this example, the balancing current I_{BL} only increases the current flowing through the battery cell CELL1 . This method can compensate the reduced current consumed by the battery cell CELL1 while detecting the voltage of the battery cell CELL4, thus saving time and reducing power consumption.

In this embodiment, t1-t0 = t3-t2 = t5-t4 = t7-t6. In other embodiments, t1-t0, t3-t2, t5-t4, and t7-t6 may not be equal. In the example of FIG. 8, when the voltage of the battery cell CELL4 is detected, the compensation circuit 620 generates a balancing current I_{BL}. In other examples, when detecting other battery cells (e.g., CELL3), the compensation circuit 620 generates a balancing current I_{BL} according to the operating current and sampling voltage of the operational amplifier corresponding to the battery cell being detected.

In the embodiments shown in FIG. 7 and FIG. 8, the compensation current generated by the compensation circuit 620 makes the overall current through the first path corresponding to the converters 211-2 and 211-3 approximately equal to zero, and the balancing current generated by the compensation circuit 620 makes the current flowing through cell CELL1 during detecting period T is approximately equal to the current flowing through other cells. Therefore, while enabling each converter to accurately detect the voltage of each battery cell, it also maintains balance between current flowing through each battery cell so that the life span of the battery pack is not shortened.

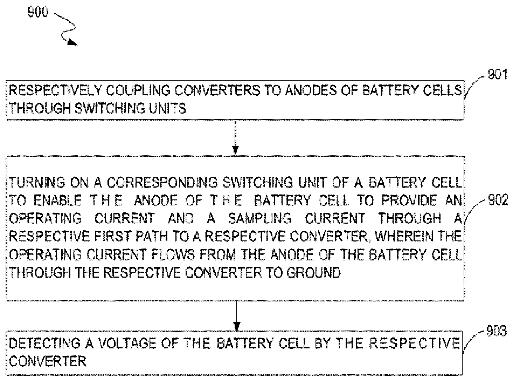

FIG. 9 shows a flowchart 900 of a method for detecting battery cell voltages.

In block 901, converters are respectively coupled to anodes of battery cells through switching units.

In block 902, a corresponding switching unit of a battery cell is turned on to enable the anode of a battery cell to provide an operating current and sampling current to a respective converter through a respective first path for the battery cell. The operating current flows from the anode of the battery cell through the respective converter to ground.

In block 903, the respective converter detects a voltage of the battery cell.

As described above, the present invention discloses a controller and a method for detecting battery cell voltages. The embodiments according to the present invention reduce the difference between the current through a first path coupled between a converter and an anode of a corresponding battery cell and the current through a second path coupled between the converter and a cathode of the corresponding battery cell, thereby enabling the converters to accurately detect the voltage of each battery cell.

While the foregoing description and drawings represent embodiments of the present invention, it will be understood that various additions, modifications and substitutions may be made therein without departing from the scope of the principles of the present invention as defined in the accompanying claims. One skilled in the art will appreciate that the invention may be used with many modifications of form, structure, arrangement, proportions, materials, elements, and components and otherwise, used in the practice of the invention, which are particularly adapted to specific environments and operative requirements without departing from the principles of the present invention. The presently disclosed embodiments are therefore to be considered in all respects as illustrative and not restrictive, the scope of the invention being indicated by the appended claims, and not limited to the foregoing description.

## Claims

1. A method for detecting voltages of a plurality of battery cells (CELL1, CELL2, CELL3, CELL4) in a battery pack,
wherein each battery cell of said plurality of battery cells is coupled to a respective converter of a plurality of converters (211_1, 211_2, 211_3),
wherein said plurality of converters are coupled to anodes of said plurality of battery cells through a plurality of switching units (212_1, 212-2, 212_3), wherein an anode of said each battery cell is coupled to said respective converter through a respective first path of a plurality of first paths, and wherein a cathode of said each battery cell is coupled to said respective converter through a respective second path of a plurality of second paths, said method comprising:
turning on a switching unit of said plurality of switching units, said switching unit corresponding to a battery cell of said plurality of battery cells, to enable said anode of said battery cell to provide an operating current and a sampling current through said respective first path for said battery cell to said respective converter for said battery cell, wherein said operating current flows from said anode of said battery cell through said respective converter for said battery cell to ground; and
detecting a voltage of said battery cell by said respective converter for said battery cell, **characterized in**:
duplicating, by a mirroring unit (410_1, 410_2, 410_3), an operating current and a sampling current of a first converter of said plurality of converters corresponding to a first battery cell of said plurality of battery cells, to reduce a difference between a current through a first path of said plurality of first paths that corresponds to said first converter and a current through a second path of said plurality of second paths that corresponds to said first converter, wherein said mirroring unit is coupled to said second path that corresponds to said first converter.

2. The method of claim 1, wherein, in said method said duplicating comprises:
generating a first duplicated current according to said operating current,
wherein said first duplicated current is proportional to said operating current; and
generating a second duplicated current according to said sampling current, wherein said second duplicated current is proportional to said sampling current,
wherein said operating current and said sampling current flow through said first path that corresponds to said first converter, and wherein said first duplicated current and said second duplicated current flow through said second path that corresponds to said first converter.

3. The method of claim 1 or 2, wherein: said mirroring unit comprises a first branch, a second branch, and a third branch; said sampling current flows through said first branch; said second branch is operable for generating said first duplicated current; said first duplicated current flows to said second branch from said second path that corresponds to said first converter; said third branch is operable for generating said second duplicated current; and said second duplicated current flows to said third branch from said second path that corresponds to said first converter.

4. The method of claim 1, 2 or 3, further comprising:
selectively turning on a switching unit of said plurality of switching units that corresponds to said first battery cell, to enable said first converter while the other converters of said plurality of converters are disabled;
enabling said mirroring unit to duplicate said current through said first path that corresponds to said first converter; and
detecting, by said first converter, a voltage of said first battery cell, wherein said method preferably further comprises:
controlling duty cycles of said plurality of switching units to reduce an average value of differences between currents through said plurality of battery cells.

5. A controller for detecting voltages of a plurality of battery cells (CELL1, CELL2, CELL3, CELL4) in a battery pack, said controller comprising:
a plurality of converters (211_1, 211_2, 211_3) coupled to said plurality of battery cells, wherein an anode of each battery cell of said plurality of battery cells is coupled to a respective converter of said plurality of converters through a respective first path of a plurality of first paths, and wherein a cathode of said each battery cell is coupled to said respective converter through a respective second path of a plurality of second paths; and
a plurality of switching units (212_1, 212_2, 212_3) coupled between said plurality of battery cells and said plurality of converters, wherein said plurality of converters are coupled to anodes of said plurality of battery cells through said plurality of switching units, wherein when a switching unit of said plurality of switches that corresponds to a battery cell of said plurality of battery cells is turned on, an anode of said battery cell provides an operating current and a sampling current through said respective first path for said battery cell to said respective converter for said battery cell, wherein said operating current flows from said anode of said battery cell through said respective converter for said battery cell to ground, **characterized in**
said controller further comprising:
a mirroring unit (410_1, 410_2, 410_3) coupled to a second path of said plurality of second paths that corresponds to a first converter of said plurality of converters that corresponds to a first battery cell of said plurality of battery cells, wherein said mirroring unit is operable for duplicating an operating current and a sampling current of said first converter to reduce a difference between a current through a first path of said plurality of first paths that corresponds to said first converter and a current through said second path that corresponds to said first converter.

6. The controller of claim 5, wherein, said mirroring unit is operable for generating a first duplicated current proportional to said operating current, and for generating a second duplicated current proportional to said sampling current, wherein said operating current and said sampling current flow through said first path that corresponds to said first converter, and wherein said first duplicated current and said second duplicated current flow through said second path that corresponds to said first converter.

7. The controller of claim 5 or 6, wherein said mirroring unit comprises a first branch, a second branch, and a third branch, and wherein: said sampling current flows through said first branch; said second branch is operable for generating said first duplicated current; said first duplicated current flows to said second branch from said second path that corresponds to said first converter; said third branch is operable for generating said second duplicated current; and said second duplicated current flows to said third branch from said second path that corresponds to said first converter.

8. The controller of one of claims 5 to 7, wherein said controller is operable for selectively turning on a switching unit of said plurality of switching units that corresponds to said first battery cell, to enable said first converter while the other converters of said plurality of converters are disabled, and for enabling said mirroring unit to duplicate said current through said first path that corresponds to said first converter, wherein, preferably,
said controller is operable for controlling duty cycles of said plurality of switching units to reduce an average value of differences between currents through said plurality of battery cells.

## Patentansprüche

1. Verfahren zur Erfassung von Spannungen einer Mehrzahl von Batteriezellen (CELL1, CELL2, CELL3, CELL4) in einem Batteriepack,
wobei jede Batteriezelle der mehreren Batteriezellen mit einem jeweiligen Konverter einer Mehrzahl von Konvertern (211_1, 211_2, 211_3) verbunden ist,
wobei die mehreren Konverter über eine Mehrzahl von Schalteinheiten (212_1, 212_2, 212_3) mit Anoden der mehreren Batteriezellen verbunden sind,
wobei eine Anode der Batteriezelle über einen ersten jeweiligen Pfad einer Mehrzahl von ersten Pfaden mit dem jeweiligen Konverter verbunden ist und
wobei eine Kathode der jeweiligen Batteriezelle über einen jeweiligen zweiten Pfad einer Mehrzahl von zweiten Pfaden mit dem jeweiligen Konverter verbunden ist, wobei das Verfahren umfasst:
Anschalten einer Schalteinheit der mehreren Schalteinheiten, wobei die Schalteinheit einer Batteriezelle der mehreren Batteriezellen entspricht, um zu ermöglichen, dass die Anode der Batteriezelle über den jeweiligen ersten Pfad für die Batteriezelle einen Betriebsstrom und einen Abtaststrom an den jeweiligen Konverter für die Batteriezelle liefert, wobei der Betriebsstrom von der Anode der Batteriezelle über den jeweiligen Konverter für die Batteriezelle zur Erde fließt; und Erfassen einer Spannung der Batteriezelle durch den jeweiligen Konverter für die Batteriezelle, **gekennzeichnet durch**
das Duplizieren eines Betriebsstroms und eines Abtaststroms eines einer ersten Batteriezelle der mehreren Batteriezellen entsprechenden ersten Konverters der mehreren Konverter durch eine Stromspiegeleinheit (410_1, 410_2, 410_3), um eine Differenz zwischen einem Strom, der durch einen dem ersten Konverter entsprechenden ersten Pfad der mehreren ersten Pfade fließt, und einem Strom, der durch einen dem ersten Konverter entsprechenden zweiten Pfad der mehreren zweiten Pfade fließt, zu verringern, wobei die Stromspiegeleinheit mit dem dem zweiten Konverter entsprechenden zweiten Pfad verbunden ist.

2. Verfahren nach Anspruch 1, wobei das Duplizieren bei dem Verfahren umfasst:
Erzeugen eines ersten duplizierten Stroms entsprechend dem Betriebsstrom, wobei der erste duplizierte Strom proportional zu dem Betriebsstrom ist; und
Erzeugen eines zweiten duplizierten Stroms entsprechend dem Abtaststrom, wobei der zweite duplizierte Strom proportional zu dem Abtaststrom ist,
wobei der Betriebsstrom und der Abtaststrom durch den ersten Pfad fließen, der dem ersten Konverter entspricht, und wobei der erste duplizierte Strom und der zweite duplizierte Strom durch den zweiten Pfad fließen, der dem ersten Konverter entspricht.

3. Verfahren nach Anspruch 1 oder 2, wobei: die Stromspiegeleinheit einen ersten Zweig, einen zweiten Zweig und einen dritten Zweig aufweist; der Abtaststrom durch den ersten Zweig fließt; der zweite Zweig betreibbar ist zum Erzeugen des ersten duplizierten Stroms; der erste duplizierte Strom von dem dem ersten Konverter entsprechenden zweiten Pfad zu dem zweiten Zweig fließt; der dritte Zweig betreibbar ist zum Erzeugen des zweiten duplizierten Stroms; und der zweite duplizierte Strom von dem dem ersten Konverter entsprechenden zweiten Pfad zu dem dritten Zweig fließt.

4. Verfahren nach Anspruch 1, 2 oder 3, ferner umfassend:
selektives Anschalten einer der ersten Batteriezelle entsprechenden Schalteinheit der mehreren Schalteinheiten, um den ersten Konverter zu aktivieren, während die anderen Konverter der mehreren Konverter deaktiviert werden;
Ermöglichen, dass die Stromspiegeleinheit den Strom dupliziert, der durch den dem ersten Konverter entsprechenden ersten Pfad fließt; und
Erfassen einer Spannung der ersten Batteriezelle durch den ersten Konverter,
wobei das Verfahren vorzugsweise ferner umfasst:
Steuern der Arbeitszyklen der Schalteinheiten zum Verringern eines Durchschnittswerts von Differenzen zwischen Strömen, die durch die mehreren Batteriezellen fließen.

5. Steuerung zur Erfassung von Spannungen einer Mehrzahl von Batteriezellen (CELL1, CELL2, CELL3, CELL4) in einem Batteriepack, wobei die Steuerung umfasst:
eine Mehrzahl von Konvertern (211_1, 211_2, 211_3), die mit den mehreren Batteriezellen verbunden sind, wobei eine Anode jeder Batteriezelle der mehreren Batteriezellen über einen jeweiligen ersten Pfad einer Mehrzahl von ersten Pfaden mit einem jeweiligen Konverter der mehreren Konvertern verbunden ist und wobei eine Kathode der jeweiligen Batteriezelle über einen jeweiligen zweiten Pfad einer Mehrzahl von zweiten Pfaden mit dem jeweiligen Konverter verbunden ist; und
eine Mehrzahl von Schalteinheiten (212_1, 212_2, 212_3), die zwischen die mehreren Batteriezellen und die mehreren Konverter geschaltet sind, wobei die mehreren Konverter über die mehreren Schalteinheiten mit Anoden der mehreren Batteriezellen verbunden sind,
wobei, wenn eine einer Batteriezelle der mehreren Batteriezellen entsprechende Schalteinheit der mehreren Schalter angeschaltet wird, eine Anode der Batteriezelle über den jeweiligen ersten Pfad für die Batteriezelle einen Betriebsstrom und einen Abtaststrom an den jeweiligen Konverter für die Batteriezelle liefert, wobei der Betriebsstrom von der Anode der Batteriezelle über den jeweiligen Konverter für die Batteriezelle zur Erde fließt,
**dadurch gekennzeichnet, dass** die Steuerung ferner umfasst:
eine Stromspiegeleinheit (410_1, 410_2, 410_3), die mit einem einem ersten Konverter der mehreren Konverter, der einer ersten Batteriezelle der mehreren Batteriezellen entspricht, entsprechenden zweiten Pfad der mehreren zweiten Pfade verbunden ist, wobei die Stromspiegeleinheit betreibbar ist zum Duplizieren eines Betriebsstroms und eines Abtaststroms des ersten Konverters, um eine Differenz zwischen einem Strom, der durch einen dem ersten Konverter entsprechenden ersten Pfad der mehreren ersten Pfade fließt, und einem Strom, der durch den dem ersten Konverter entsprechenden zweiten Pfad fließt, zu verringern.

6. Steuerung nach Anspruch 5, wobei die Stromspiegeleinheit betreibbar ist zum Erzeugen eines ersten duplizierten Stroms, der proportional zu dem Betriebsstrom ist, und zum Erzeugen eines zweiten duplizierten Stroms, der proportional zu dem Abtaststrom ist, wobei der Betriebsstrom und der Abtaststrom durch den dem ersten Konverter entsprechenden ersten Pfad fließen und wobei der erste duplizierte Strom und der zweite duplizierte Strom durch den dem ersten Konverter entsprechenden zweiten Pfad fließen.

7. Steuerung nach Anspruch 5 oder 6, wobei die Stromspiegeleinheit einen ersten Zweig, einen zweiten Zweig und einen dritten Zweig aufweist und wobei:
der Abtaststrom durch den ersten Zweig fließt; der zweite Zweig betreibbar ist zum Erzeugen des ersten duplizierten Stroms; der erste duplizierte Strom von dem dem ersten Konverter entsprechenden zweiten Pfad zu dem zweiten Zweig fließt;
der dritte Zweig betreibbar ist zum Erzeugen des zweiten duplizierten Stroms; und
der zweite duplizierte Strom von dem dem ersten Konverter entsprechenden zweiten Pfad zu dem dritten Zweig fließt.

8. Steuerung nach einem der Ansprüche 5 bis 7, wobei die Steuerung betreibbar ist zum selektiven Anschalten einer der ersten Batteriezelle entsprechenden Schalteinheit der mehreren Schalteinheiten, um den ersten Konverter zu aktivieren, während die anderen Konverter der mehreren Konverter deaktiviert werden, und zur Aktivierung der Stromspiegeleinheit zum Duplizieren des durch den dem ersten Konverter entsprechenden ersten Pfad fließenden Stroms, wobei vorzugsweise
die Steuerung betreibbar ist zum Steuern von Arbeitszyklen der mehreren Schalteinheiten, um einen Durchschnittswert von Differenzen zwischen Strömen, die durch die mehreren Batteriezellen fließen, zu verringern.

## Revendications

1. Procédé de détection de tension d'une pluralité de cellules de batterie (CELL1, CELL2, CELL3, CELL4) dans un bloc de batterie,
dans lequel chaque cellule de batterie de la pluralité de cellules de batterie est connecté à un convertisseur respectif d'une pluralité de convertisseurs (211_1, 211_2, 211_3),
dans lequel la pluralité de convertisseurs est connectée à des anodes de la pluralité de cellules de batterie par l'intermédiaire d'une pluralité d'unités de commutation (212_1, 212_2, 212_3),
dans lequel une anode de chaque cellule de batterie est connectée au convertisseur respectif par l'intermédiaire d'un premier chemin respectif d'une pluralité de premiers chemins, et dans lequel une cathode de chaque cellule de batterie est connectée au convertisseur respectif par l'intermédiaire d'un deuxième chemin respectif d'une pluralité de deuxièmes chemins, le procédé comprenant :
la mise en marche d'une unité de commutation de la pluralité d'unités de commutation, l'unité de commutation correspondant à une cellule de batterie de la pluralité de cellules de batterie, pour permettre à l'anode de la cellule de batterie de fournir un courant de fonctionnement et un courant de détection au convertisseur respectif pour la cellule de batterie par l'intermédiaire du premier chemin respectif pour la cellule de batterie, le courant de fonctionnement s'écoulant de l'anode de la cellule de batterie vers la terre par l'intermédiaire du convertisseur respectif pour la cellule de batterie; et
détecter une tension de la cellule de batterie par le convertisseur respectif pour la cellule de batterie, **caractérisé par**
la duplication d'un courant de fonctionnement et d'un courant de détection d'un premier convertisseur de la pluralité de convertisseurs correspondant à une première cellule de batterie de la pluralité de cellules de batterie par une unité miroir de courant (410_1, 410_2, 410_3) afin de réduire une différence entre un courant circulant à travers un premier chemin de la pluralité de premiers chemins correspondant au premier convertisseur et un courant circulant à travers un deuxième chemin de la pluralité de deuxièmes chemins correspondant au premier convertisseur, l'unité de miroir de courant étant connectée au deuxième chemin correspondant au deuxième convertisseur.

2. Procédé selon la revendication 1, dans lequel la duplication dans le procédé comprend:
la génération d'un premier courant dupliqué en fonction du courant de fonctionnement, le premier courant dupliqué étant proportionnel au courant de fonctionnement; et
générer un deuxième courant dupliqué en fonction du courant d'échantillonnage, le deuxième courant dupliqué étant proportionnel au courant d'échantillonnage, dans lequel le courant de fonctionnement et le courant d'échantillonnage circulent à travers le premier chemin correspondant au premier convertisseur, et dans lequel le premier courant dupliqué et le deuxième courant dupliqué circulent à travers le deuxième chemin correspondant au premier convertisseur.

3. Procédé selon la revendication 1 ou 2, dans lequel: l'unité miroir de courant comprend une première branche, une deuxième branche et une troisième branche; le courant d'échantillonnage circule à travers la première branche; la deuxième branche est utilisable pour générer le premier courant dupliqué; le premier courant dupliqué circule depuis le deuxième chemin correspondant au premier convertisseur vers la deuxième branche; la troisième branche est utilisable pour générer le deuxième courant dupliqué; et le deuxième courant dupliqué circule depuis le deuxième chemin correspondant au premier convertisseur vers la troisième branche.

4. Procédé selon la revendication 1, 2 ou 3, comprenant en outre:
activer sélectivement une unité de commutation de la pluralité d'unités de commutation correspondant à la première cellule de batterie pour activer le premier convertisseur tout en désactivant les autres convertisseurs de la pluralité de convertisseurs;
permettre à l'unité miroir de courant de dupliquer le courant circulant dans le premier chemin correspondant au premier convertisseur; et
détecter une tension de la première cellule de batterie par le premier convertisseur, le procédé comprenant de préférence en outre:
commander les cycles de fonctionnement des unités de commutation pour réduire une valeur moyenne des différences entre les courants circulant à travers la pluralité des cellules de batterie.

5. Organe de commande pour détecter les tensions d'une pluralité de cellules de batterie (CELL1, CELL2, CELL3, CELL4) dans un bloc de batterie, l'organe de commande comprenant:
une pluralité de convertisseurs (211_1, 211_2, 211_3) connectés à la pluralité de cellules de batterie, une anode de chaque cellule de batterie de la pluralité de cellules de batterie étant connectée à un convertisseur respectif de la pluralité de convertisseurs par l'intermédiaire d'un premier chemin respectif d'une pluralité de premiers chemins, et une cathode de la cellule de batterie respective étant connectée au convertisseur respectif par l'intermédiaire d'un deuxième chemin respectif d'une pluralité de deuxièmes chemins; et comprenant une pluralité d'unités de commutation (212_1, 212_2, 212_3) connectées entre la pluralité de cellules de batterie et la pluralité de convertisseurs, la pluralité de convertisseurs étant connectée à des anodes de la pluralité de cellules de batterie par l'intermédiaire de la pluralité d'unités de commutation,
dans lequel, lorsqu'une unité de commutation de la pluralité de commutateurs correspondant à une cellule de batterie de la pluralité de cellules de batterie est activée, une anode de la cellule de batterie fournit un courant de fonctionnement et un courant d'échantillonnage au convertisseur respectif pour la cellule de batterie à travers ledit premier chemin respectif pour la cellule de batterie, le courant de fonctionnement circulant de l'anode de la cellule de batterie à la terre à travers du convertisseur respectif pour la cellule de batterie,
**caractérisé en ce que**
**en ce que** l'organe de commande comprend en outre:
une unité miroir de courant (410_1, 410_2, 410_3) connectée à un deuxième chemin de la pluralité de deuxièmes chemins correspondant à un premier convertisseur de la pluralité de convertisseurs correspondant à une première cellule de batterie de la pluralité de cellules de batterie, l'unité miroir de courant étant utilisable pour dupliquer un courant de fonctionnement et un courant d'échantillonnage du premier convertisseur afin de réduire une différence entre un courant circulant à travers un premier chemin de la pluralité de premiers chemins correspondant au premier convertisseur et un courant circulant à travers le deuxième chemin correspondant au premier convertisseur.

6. Organe de commande selon la revendication 5,
dans lequel l'unité miroir de courant est utilisable pour générer un premier courant dupliqué proportionnel au courant de fonctionnement et pour générer un deuxième courant dupliqué proportionnel au courant d'échantillonnage, dans lequel le courant de fonctionnement et le courant d'échantillonnage circulent à travers le premier chemin correspondant au premier convertisseur et dans lequel le premier courant dupliqué et le deuxième courant dupliqué circulent à travers le deuxième chemin correspondant au premier convertisseur.

7. Organe de commande selon la revendication 5 ou 6, dans lequel l'unité miroir de courant comprend une première branche, une deuxième branche et une troisième branche et dans lequel: le courant d'échantillonnage circule à travers la première branche; la deuxième branche est utilisable pour générer le premier courant dupliqué; le premier courant dupliqué circule depuis le deuxième chemin correspondant au premier convertisseur vers la deuxième branche; la troisième branche est utilisable pour générer le deuxième courant dupliqué; et le deuxième courant dupliqué circule depuis le deuxième chemin correspondant au premier convertisseur vers la troisième branche.

8. Organe de commande selon l'une quelconque des revendications 5 à 7, l'organe de commande étant utilisable pour activer sélectivement une unité de commutation de la pluralité d'unités de commutation correspondant à la première cellule de batterie afin d'activer le premier convertisseur tout en désactivant les autres convertisseurs de la pluralité de convertisseurs, et pour activer l'unité miroir de courant afin de dupliquer le courant circulant à travers le premier chemin correspondant au premier convertisseur, de préférence
l'organe de commande étant utilisable pour commander des cycles de fonctionnement de la pluralité d'unités de commutation afin de réduire une valeur moyenne de différences entre des courants circulant à travers la pluralité de cellules de batterie.
